# EUROPEAN PATENT APPLICATION

(11) **EP 1 798 773 A2**
(43) Date of publication of application: **20.06.2007**
(21) Application number: 06126396.8
(22) Date of filing: 18.12.2006
(51) Int. Cl.: H01L 29/812, H01L 29/40

(54) **Dual field plate MESFET**

(30) Priority: 19.12.2005 US 305943
(71) Applicant: M/A-COM, INC., Lowell, MA 01854 (US)
(72) Inventor: Winslow, Thomas Aaron, Salem, VA 24153 (US)
(74) Representative: Johnstone, Douglas Ian

(57) **Abstract**

A dual field plate MESFET (90) and method of forming a MESFET. The MESFET (90) includes a gate electrode (100) and a drain electrode (96), with the gate electrode (100) and drain electrode (96) formed on a substrate (105). The MESFET further includes a gate side field plate (110) at the gate electrode (100) and a drain side field plate (112) in proximity to the drain electrode (96) and extending over a burnout improvement region in the substrate (105).

## Description

This invention relates generally to semiconductor devices and, more particularly, to Metal-Semiconductor-Field-Effect-Transistors (MESFETs).

MESFETs, for example, GaAs MESFETs, also referred to as Schottky-gate field-effect transistors (FETs), may be used in a variety of different electronic applications. These applications range from providing switching operations (e.g., high-speed digital switching) to providing signal amplification. Further, these applications encompass commercial, industrial and military uses.

MESFETs are often included in devices for use in microwave frequency communications and radar. The devices, as well as other devices and systems using or incorporating MESFETs have continually increasing power requirements. For example, the desired power output per MESFET device, such as, per transistor surface area continually increases. The power output of transistors also has improved greatly due to the operation at high voltages such that a single transistor can provide more power, thereby allowing the use of a reduced number of transistors for a particular application. The use of a reduced number of transistors results in reduced cost, as well as reduced size and weight for a device incorporating transistors. Thus, fewer MESFET may be used, for example, in high power applications.

Known GaAs MESFETs use a metal electrode in direct contact with a doped GaAs channel region to form a Schottky gate junction. A voltage applied to the gate electrode or junction influences the channel carrier density in the vicinity of the gate electrode such that current flows from a drain to a source through the channel region. Essentially, a Schottky barrier is provided as the gate electrode rather than a semiconductor junction. The drain-to-source voltage can be modulated by varying the voltage applied between the gate electrode and one of the other electrodes of the MESFET. Accordingly, switching operation or amplification can be provided using MESFETs.

In operation, the instantaneous source-to-drain voltage of MESFETs may transition from a relatively high value (approximately twice the operational voltage) to a small value, with the associated instantaneous drain-to-source current transitioning in the opposite direction. The maximum allowed drain-to-source voltage must be limited so as to not exceed the breakdown voltage of the transistor. The breakdown voltage is generally determined by the structural parameters of the transistor, which may include, for example, the spacing between the gate electrode and the drain electrode, the breakdown field of the substrate material (e.g., germanium, silicon, gallium arsenide, diamond, etc.), the doping levels of the various regions, the dimensions of the doped regions, and the configuration or shape of the gate electrode and adjoining material. Further, the breakdown field of a material is related to the band gap of the material. Thus, materials with larger band gaps can be used to form transistors with higher breakdown voltages.

It is known to form a field plate MESFET allowing high voltage (e.g., twenty-four to twenty-eight volts) and high efficiency operation. These known field plate MESFETs also provide high power density. These field plate MESFETs typically include a MESFET gate Schottky contact and an overlaid metal layer that either overlays the gate contact separated by a dielectric material (floating field plate) or directly contacts the gate Schottky and overlays an FET channel, thereby forming a metal-insulator-semiconductor (MIS) structure between the gate and the drain. The gate field plate spreads out high intensity electric fields between the gate and the drain, which reduces the peak intensity, thereby allowing higher voltage operation.

In these gate field plate MESFETs, the normally strong electric fields created in the gate-drain region that can cause burnout are reduced by the field spreading effect of the gate field plate. However, the gate field plate does not affect the high field regions in the drain ohmic contact region that also can cause channel burnout. This potential for burnout near the drain contact limits the operating range and robustness of the MESFET for high voltage applications. Thus, the high voltage operating characteristics of the MESFET are limited by the gate Schottky and/or the drain contact regions.

The solution is provided by a Metal-Semiconductor-Field-Effect-Transistor (MESFET) that includes a gate electrode and a drain electrode, with the gate electrode and drain electrode formed on a substrate. The MESFET further includes a gate side field plate at the gate electrode and a drain side field plate in proximity to the drain electrode and extending over a burnout improvement region in the substrate.

The solution is also provided by a method of forming a Metal-Semiconductor-Field-Effect-Transistor (MESFET) and includes forming a gate electrode on a substrate and forming a drain electrode on the substrate. The method further includes forming a gate side field plate at the gate electrode and forming a drain side field plate in proximity to the drain electrode and over an n' portion of the substrate.

The invention will now be described by way of example with reference to the accompanying drawings in which:

Figure 1 is a top plan view of a plurality of Metal-Semiconductor-Field-Effect-Transistors (MESFETs) formed in accordance with an exemplary embodiment of the invention and formed on a die.

Figure 2 is a cross-sectional view of a MESFET formed in accordance with an exemplary embodiment of the invention.

Figure 3 is a cross-sectional view of a MESFET formed in accordance with an exemplary embodiment of the invention showing a burnout reduction region.

Figure 4 is a cross-sectional view of a MESFET formed in accordance with another exemplary embodiment of the invention.

Various embodiments of the invention provide a Metal-Semiconductor-Field-Effect-Transistor (MESFET) having a drain side field plate. More particularly, in addition to a gate Schottky and a gate side field plate extending toward a drain contact, various embodiments of a MESFET include a drain side field plate that extends towards the gate contact. The formation of the drain side field plate may be provided at the same time as the formation of the gate field plate.

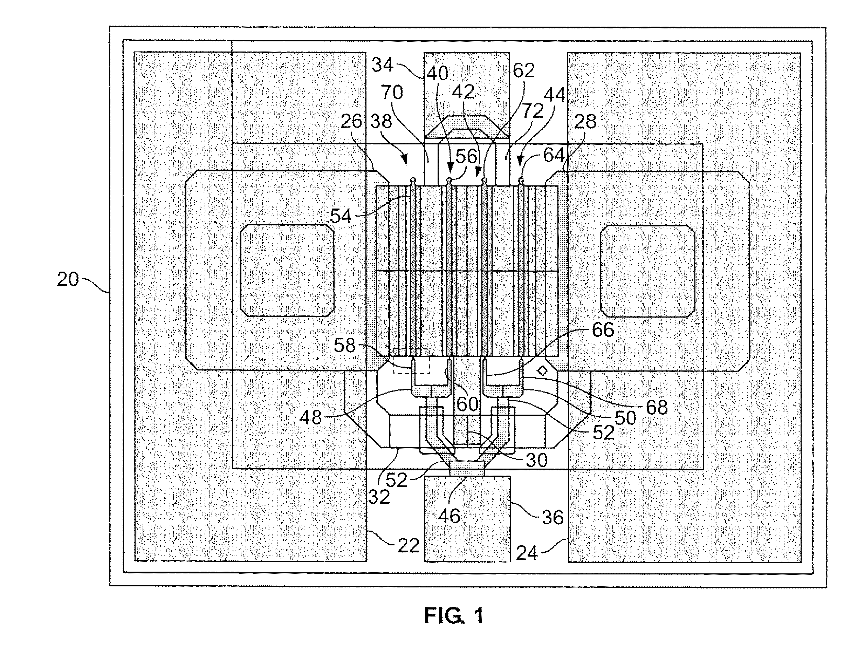

In general, and as shown in Figure 1, one or more MESFETs formed in accordance with various embodiments of the invention may be formed on a die 20. More particularly, a first ground plane 22 and a second ground plane 24 include metallizations or metalized portions 26, 28 and 30 defining conductors or electrodes that are electrically coupled in parallel by a conductive path 32. A drain electrode 34, which may be configured as a contact or bonding pad and a gate electrode 36, which also may be configured as a contact or bonding pad are also provided for connecting to the MESFETs.

Specifically, one or more MESFETs, which may be configured as individual elements, are formed on the die 20. For example, MESFETs 38, 40, 42 and 44 may be formed on the die 20. The drain electrode 34 is connected to a drain region (not shown) of the MESFETS 38, 40, 42 and 44 via the metalized portions 70 and 72. The gate electrode 36 optionally may be connected to a pair of power dividers or splitters 48 and 50 via a metalized portion 46 and metallizations 52. The metallizations 52 may be configured to include portions or segments having different widths to provide impedance transformation as is known. In an exemplary embodiment, the power divider or splitter 48 receives a signal to be amplified from the metallizations 52, and applies power, and in particular, voltage to corresponding gate electrodes 54 and 56. The power may be applied in substantially equal amounts via conductors 58 and 60, respectively. Similarly, the power divider or splitter 50 receives a signal to be amplified from the metallizations 52, and applies power, and in particular, voltage to corresponding gate electrodes 62 and 64. The power may be applied in substantially equal amounts via conductors 66 and 68, respectively. It should be noted that although the MESFETs 38, 40, 42 and 44 are configured for operation to provide power amplification, the various embodiments are not limited to applications involving power amplification. The various embodiments of the invention for forming a MESFET may be used in connection with any system or device wherein a MESFET or FET is desired or needed.

Each of the gate electrodes 54, 56, 62 and 64 includes a source region on one side and a drain region on the other side. In particular, the MESFET 38 includes the gate electrode 54, to the left of which is a source conductor or electrode defined by the metalized portion 26, and to the right of which is a drain electrode 70. The MESFET 40 includes the gate electrode 56, to the left of which is the drain electrode 70 and to the right of which is a source conductor or electrode defined by the metalized portion 30. The MESFET 42 includes the gate electrode 62, to the left of which is the source conductor or electrode defined by the metalized portion 30 and to the right of which is a drain electrode 72. The MESFET 44 includes the gate electrode 64, to the left of which is the drain electrode 72 and to the right of which is a source conductor or electrode defined by the metalized portion 28. In this exemplary configuration, which is not limiting to the various embodiments of the invention, the four MESFETs 38, 40, 42 and 44 are arranged in parallel to define a MESFET unit.

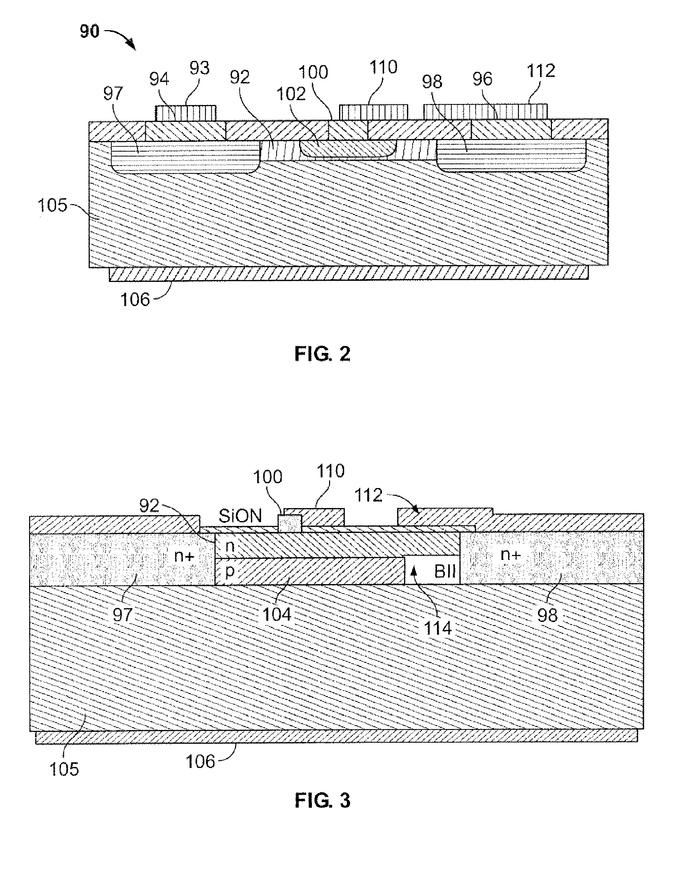

Various embodiments of the invention generally provide a MESFET 90 as shown in Figure 2. The MESFET 90 may be constructed of different materials as desired or needed, for example, based on a particular application. The materials that may be used include, but are not limited to, Gallium Arsenide (GaAs), Indium Phosphide (InP) or Silicon Carbide (SiC). More particularly, a conducting channel 92 (e.g., channel formed from an n-type implant and a p-type implant) is formed between a source ohmic contact region 94 (e.g., source electrode) and a drain ohmic contact region 96 (e.g. drain electrode). Specifically, the conducting channel 92 is formed between an n+ region 97 of the source contact region 94 and an n+ region 98 of the drain contact region 96. Further, a gate, and more particularly, a Schottky gate 100 controls the carrier flow from the source contact region 94 to the drain contact region 96. A depletion layer 102 is provided below the Schottky gate 100, the width of which may be varied to control the flow in the conducting channel 92. The various regions of the MESFET 90 are generally formed on a semi-insulating layer 105, for example, a GaAs semi-insulating layer or other semi-insulating layer. A contact 106, for example, a metal contact plate is provided below the p-type layer 104 opposite the source contact region 94 and the drain contact region 96.

In various embodiments, the MESFET 90 also includes a gate side field plate 110 and a drain side field plate 112. The gate side field plate 110 extends generally parallel to and over at least a portion of the Schottky gate 100. The gate side field plate 110 extends towards the drain contact region 96. The drain side field plate 112 extends generally parallel to and over at least a portion of the drain contact region 96. The drain side field plate 112 extends towards the Schottky gate 100. In an exemplary embodiment as shown in Figure 3, the drain side field plate 112 is formed substantially above or over a burnout reduction region 114. Further, a source contact 93 extends generally parallel to and over at least a portion of the source contact region 94.

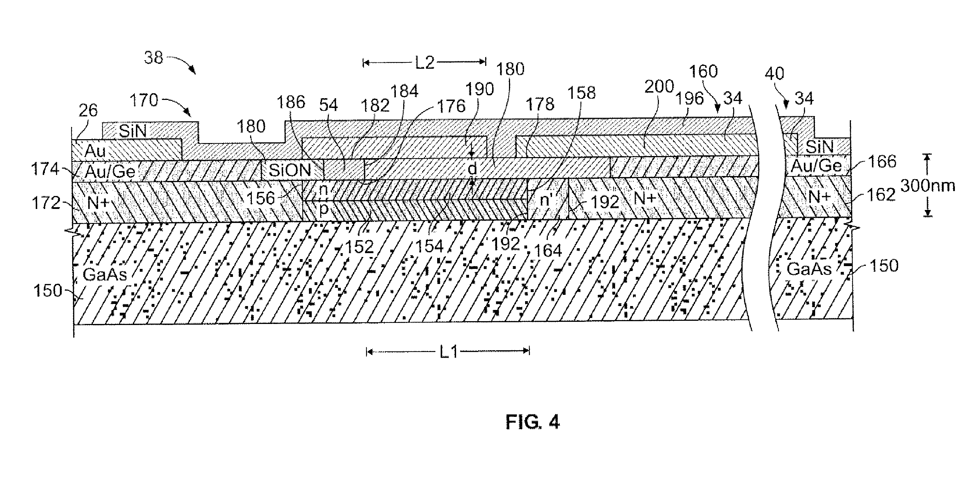

More particularly, Figure 4 is a cross-sectional view of the MESFET 38 and a partial cross-sectional view of the MESFET 40. It should be noted that all of the MESFETs 38, 40, 42 and 44 are similar in structure. Accordingly, although a description of the MESFETs 38 and 40 is provided, the MESFETs 42 and 44 have correspondingly similar structure. With respect to Figure 4, a GaAs substrate 150 has a p-type doped sub-channel region 152, and a n-type doped channel region 154 above the sub-channel region 152. The channel region 154 extends from a source end 156 to a drain end 158. The drain, identified generally as 160, includes an n+ doped portion 162 and an n' portion 164 adjacent the drain end 158 of the channel 154. The n' portion 164 generally defines a burnout improvement implant region, identified in Figure 3 as 114. A drain ohmic contact material formed as a layer 166, for example, a germanium-gold (Au/GE) layer, overlies at least a portion of the n+ doped region 162 of the drain 160. The drain electrode 34 overlies and provides electrical contact with at least a portion of the drain material 166 of the drain 160. The source 170 of the MESFET 38 includes an n+ doped portion 172 and a source ohmic contact formed as an overlying layer 174, for example, a germanium/gold (Au/Ge) layer. The source electrode 26, for example, Gold (Au) conductor overlies and provides conductive contact with the overlying ohmic contact layer 174 of the source 170.

The gate electrode 54 overlies a portion of the channel 154, and at a lower surface 176 is in contact with the channel 154 to form a Schottky junction. The gate electrode 54 may be asymmetrically formed on a channel region 178 such that the gate electrode is closer to the source 170 than to the drain 160. An insulating dielectric material 180, for example, a material such as silicon oxynitride (SiON) overlies a portion of the source n+ doped portion 172 that is nearest the gate electrode 54, and also overlies that portion of the channel 154 between the gate electrode 54 and the overlying layer 174, to thereby isolate the gate electrode 54 from the source 170. An electrically conductive field plate 190, also referred to herein as the gate side field plate, is in mechanical and electrical contact with an upper surface 182 of the gate conductor 54. Additionally, an electrically conductive field plate 200, also referred to herein as the drain side field plate, is formed generally over the n' portion 164.

It should be noted that in the cross-sectional view of Figure 4, the long dimension, or width, of the gate electrode 54 and of the channel 154 extend into the Figure. The length of the channel 154 extends parallel to the direction of drain-to-source current flow, which current flow is parallel to the direction of the arrows designated "L1" and "L2."

In an exemplary embodiment, electrically conductive field plate 190 extends to the right in the direction of source-to-drain current flow beyond an edge 184 of the gate conductor 54 that is nearest the drain 160, and also extends to the left beyond that edge 186 of the gate conductor 54 that is adjacent to or nearest the source 170. The portion of the electrically conductive field plate 190 that is not supported by the gate conductor 54 overlies and is supported by the layer isolation material 178, which is supported by portions of the n+ doped portion 172 of the source 170, by the channel 154, and by the channel regions 164 and 162. It should be noted, however, that the electrically conductive field plate 190 can extend over a portion of the gate conductor 54, or extend beyond the gate schottky edge 186 toward the source contact 170. In this embodiment, the conductive field plate 200 extends generally over the n' portion 164 and beyond edges 192 of the n' portion 164 or forms partial coverage of the n' region 164. However, the conductive field plate 200 is not in contact with the n' portion 164. In particular, the conductive field plate 200 extends from a region near the conductive field plate 190 to a region near the drain electrode 34. Essentially, the conductive field plate 200 forms the drain electrode 34 and extends towards the gate electrode 54 in a plane or layer above or over the entire n' portion 164. The electrically conductive field plate 190 and the electrically conductive field plate 200 are provided (e.g., formed) on the same layer or on the same plane of the MESFET 38 or 40. The gate and drain side field plates are formed using either lift-off or plated metal, including, but not limited to, gold. It should be noted that the dimension, including the shape and size of the electrically conductive field plate 190 and the electrically conductive field plate 200 may be the same or different, and may be modified as desired or needed. The gate and drain side field plates, in an exemplary embodiment, are between 1-3um in dimension, for example, depending on the particular application for the MESFET.

Additionally, the MESFETs 38 and 40 are covered with a protective coating or layer 196 of dielectric material such as silicon nitride (SiN). It further should be noted that the MESFET 38 is to the left of and adjacent to the MESFET 40. Accordingly, the drain 160 of the MESFET 38 is adjacent the MESFET 40. Thus, the dimensions of the overall structure may be reduced by using the same structural elements for the drains of both the MESFETs 38 and 40. The portion of the MESFET 40 that is visible in FIG. 4 includes a continuation of the substrate 150, the n+ doped portion 162, the layer 166, and the drain electrode 34. This mirror-image layout of the MESFETs allows each drain structure to be used for two separate or different adjacent MESFETs. Accordingly, the source structure associated with source electrode 26 and lying between the gate electrodes 56 and 62, allows the use of the source structure for a pair of adjacent MESFETs, such as MESFETs 40 and 42.

Thus, various embodiments of the invention provide a MESFET having a drain side field plate in addition to a gate side field plate. The drain side field plate spreads out electric fields, under open channel conditions, to reduce the likelihood of open channel burnout in the region where the n+ drain contact transitions to the p type co-implant in the gate-drain region. The drain side field plate also acts as a heat spreader in the local region of the drain contact 160. High voltage operation of field plate MESFETs create a higher voltage drop across the drain contact region from the area of high conductivity 162, to the region of lower conductivity 154. This voltage drop also generates heat that must be spread to prevent thermal burnout. The heat typically flows to the lower temperature backside of the MESFET, but the proximity of the MESFET also acts as a heat spreader to pull heat generated in the drain contact region away from the MESFET channel. The robustness of the MESFET is thereby increased with the drain side field plate. Further, because the electrically conductive field plates are provided at the same layer or on the same plane of the MESFET, these electrically conductive field plates may be formed at the same processing step or operation when forming the MESFET.

It should be noted that MESFETs constructed according to various embodiments of the invention may be configured and arranged in different manners. For example, a parallel arrangement as described herein is not the only contemplated arrangement, and MESFETs may be arranged at different orientations and angles relative to each other. Additionally, the number of MESFET elements in a unit may be modified and/or separate MESFETs or individual units may be provided. Further, different materials for forming the various layers, conductors and electrodes of the MESFET may be provided and are not limited to the materials described herein.

## Claims

1. A Metal-Semiconductor-Field-Effect-Transistor (MESFET) (90) comprising:
a gate electrode (100);
a drain electrode (96), the gate electrode (100) and drain electrode (96) formed on a substrate (105);
a gate side field plate (110) at the gate electrode (100); and
a drain side field plate (112) in proximity to the drain electrode (96) and extending over a burnout improvement region (114) in the substrate (105).

2. A MESFET (90) in accordance with claim 1 wherein the gate side field plate (110) extends over the entire gate electrode (100).

3. A MESFET (90) in accordance with claim 1 wherein the gate side field plate (110) extends over a portion of the gate electrode (100).

4. A MESFET (90) in accordance with claim 1, 2 or 3 wherein the gate side field plate (110) and the drain side field plate (112) are in a single plane.

5. A MESFET (90) in accordance with any preceding claim further comprising a protective layer (196) and wherein the gate side field plate (110) and the drain side field plate (110) are separated by at least a portion of the protective layer (196).

6. A MESFET (90) in accordance with any preceding claim wherein the drain side field plate (112) extends towards the gate electrode (100) from the drain electrode (96).

7. A MESFET (90) in accordance with any preceding claim wherein the gate side field plate (110) extends towards the drain electrode (96) from the gate electrode (100).

8. A MESFET (90) in accordance with any preceding claim wherein the gate side field plate (110) and the drain side field plate (112) are formed during a single processing operation.

9. A MESFET (90) in accordance with any preceding claim wherein the gate side field plate (110) and drain side field plate (112) each comprise electrically conductive field plates (190, 200).

10. A MESFET (90) in accordance with any preceding claim wherein the gate side field plate (110) and drain side field plate (112) are of substantially the same size.

11. A MESFET (90) in accordance with any of claims 1 to 9 wherein the gate side field plate (110) and drain side field plate (112) are of different sizes.

12. A MESFET in accordance with any preceding claim wherein the gate side field plate (110) and drain side field plate (112) are provided in a plane with the gate electrode (100) and drain electrode (96).

13. A method of forming a Metal-Semiconductor-Field-Effect-Transistor (MESFET) (90), the method comprising:
forming a gate electrode (100) on a substrate (105);
forming a drain electrode (96) on the substrate (105);
forming a gate side field plate (110) at the gate electrode (100); and
forming a drain side field plate (112) in proximity to the drain electrode (96) and over an n' portion of the substrate (105).

14. A method in accordance with claim 16 wherein the gate side field plate (110) and drain side field plate (112) are formed in a single plane.
